# EUROPEAN PATENT SPECIFICATION

(11) **EP 2 242 595 B1**
(45) Date of publication and mention of the grant of the patent: **13.07.2011**
(21) Application number: 09702587.8
(22) Date of filing: 16.01.2009
(51) Int. Cl.: B21D 28/04, B26F 1/00, B41F 27/00, G03F 9/00

(54) **PRINTING PLATES**
DRUCKPLATTEN
PLAQUES D'IMPRESSION

(30) Priority: 18.01.2008 EP 08000936
(43) Date of publication of application: 27.10.2010
(73) Proprietor: Rexam Beverage Can Europe Limited, Luton, Bedfordshire LU1 3LG (GB)
(72) Inventor: BILLGREN, Sven, S-241 91 Eslöv (SE); HOPKINSON, Christopher, Carey, Sheffield S35 7BX (GB)
(74) Representative: Dunlop, Brian Kenneth Charles
(86) International application number: PCT/GB2009/000105
(87) International publication number: WO 2009/090389

(56) References cited:
- US-A- 4 018 414
- US-A- 5 454 247
- US-B1- 6 550 389

## Description

This invention relates to printing plates and punches for punching location holes in such plates. The plates are particularly suitable for use in machines for printing on cans.

US 5454247 A describes method and apparatus for punching and bending a lithographic plate to match a particular press.

Traditionally, printing plates carrying an image to be printed are located on cylinders in a printing machine. The position of the printing plate on the cylinder is critical to allowing the various colours making up the image to be aligned. Many systems employ a series of holes accurately punched in a steel backed plate, which carries the image and these holes are fitted on ground steel pins located on the cylinder. When using conventional photographic films to carry the image from the digital file to the printing plate, the position of these holes is often controlled by punching holes in the film carrying the image and locating the film before exposure on pins positioned in punch holes in the plate. Although these systems are functional, they cannot be employed where the image is transferred directly from the digital file to the printing plate without use of photographic film.

From one aspect, the present invention includes a method of providing registration holes in a printing plate having a defined working area in the form of an image including forming a raised portion on the part of the plate not contained within the working area for providing a datum in a first direction and an opening in the raised portion, one wall of the opening providing a datum in a direction orthogonal to the first.

The raised portion may be laser engraved directly from the digital file. The image may be laser engraved from a digital image file. Preferably, the raised portion and the image or working area can be formed simultaneously in this way.

This approach is extremely flexible and is particularly suitable when using direct laser engraving to transfer the image from the digital file to the raised image printing plate because the resulting area has very straight shoulders compared to photographically exposed printing plates. The raised portion can therefore provide extremely accurate datums and the exact position of those datums can be readily adjusted in the digital file to suit any particular printing press or other working machine. To date, alternative methods of punching directly laser engraved plates require the use of complex optical sensors to locate register marks engraved into the plates surface. These systems are typically expensive to build and operate relatively slowly.

The invention also includes a printing plate having a working area in the form of an image and a non-working area, the plate having a raised portion for providing a datum in a first direction and an opening in the portion, one wall of the opening providing a datum in a direction orthogonal to the first.

The opening may be generally central in the raised portion. The plate may be generally rectangular and the raised portion may extend parallel to an edge thereof. Additionally or alternatively, the working area may be generally rectangular and the raised portion may extend parallel to an edge thereof.

The plate may include an area for receiving punched location holes, so punch hole area being spaced from the working area and the raised portion. The image and/or raised portion may be formed by direct laser engraving from a digital file.

Preferably, the method uses a punch assembly for punching location holes in a printing plate including a bed for receiving the plate, a punch extending along a dimension of the bed and a guide extending at an angle to the punch whereby the guide has a proportion overhanging the bed to define a recess for receiving an edge and to define a datum edge against which a raised portion can engage and having a formation for defining a further datum orthogonal to the datum edge.

The formation may be in the form of a projection and the projection may be located generally centrally of the datum edge.

The invention may be performed in various ways and specific embodiments will now be described, by way of example, with reference to the accompanying drawings in which:-
Figure 1 is a plan view of a printing plate;
Figure 2 is a side view of a guide mounted on the base of a punch assembly with a workpiece being placed in registration on the guide;
Figure 3 is a planned view of the guide of Figure 2.
Figure 4 is a photograph from one side and one end of a punch assembly incorporating a guide as illustrated in Figures 2 and 3; and
Figure 5 is a view from one end and above of the punch assembly in figure 4, showing the location of a printing plate; and
Figure 6 is a schematic layout of a can printer or decorator.

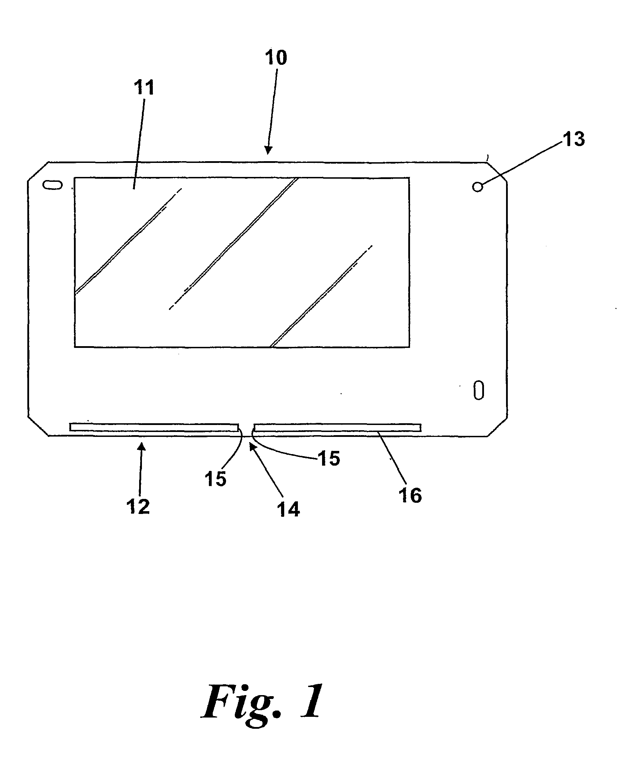

A printing plate 10 is illustrated in Figure 1. The plate 10 is an engraved relief steel backed letter press printing plate, which has an engraved image 11 formed on one part, a raised bar 12 formed on another part. The raised portion 12 consists of a bar extending generally parallel to the image area 11 and an edge of the plate 10. The bar has an opening 14, adjacent at centre, which defines a pair of lateral walls 15. The surface 16 and one of the walls 15 form orthogonal datums, which have positions defined relative to the image area 11.

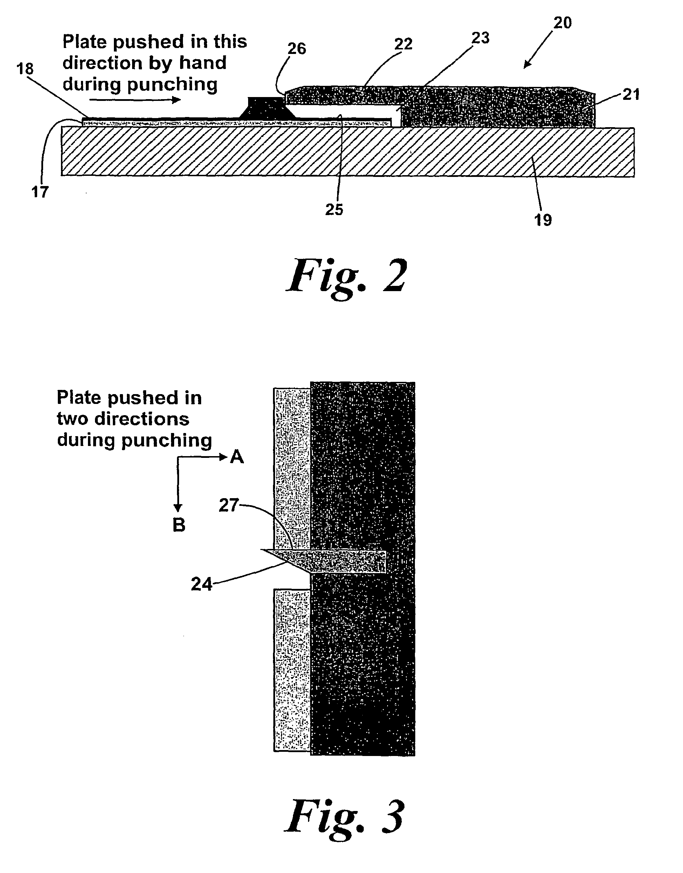

The image in area 11 and the raised portion 12 are formed by direct laser engraving from a digital image file. Typically, the printing plate will consist of a steel backing 17 and a polymer engravable upper portion 18 (see Figure 2). The portion 18 could be made of any suitable material, including metal. Both the image and the raised portion are laser engraved in the upper portion 18 by removing unwanted material with the laser. The use of laser engraving not only enables the image and raised portion to be formed directly from the digital image file, it also means that the datum surfaces can be formed with great precision.

As can be seen in Figures 2 and 3, the datums 15, 16 can be used to locate the plate 10 precisely in two dimensions, having first been located in the third dimension by a support. This support 19 is provided by the base plate or bed of a punch assembly. A guide 20 is mounted on the bed 19 and consists of a base 21, which is mounted on the bed 19, an overhanging portion 22 that defines a recess 23 below it and a lateral projection 24 that extends out of the overhang portion 22 adjacent centre point of the guide 20. As can be seen in Figures 2 and 3, a plate 10 can be pushed along the bed 19 towards the guide so that an edge portion 25 can enter the recess 23, allowing the datum surface 16 to engage a datum edge 26 of the overhang 22. This will only occur if the projection 24 enters the opening 14. The plate 10 is then moved longitudinally to achieve engagement of a longitudinally facing face 27 of the projection 24 against a wall 15. This is achieved by first moving the plate in the direction of the arrow A and then moving the plate in the direction of the arrow B.

It will be understood that the plate 10 is now located precisely in all three dimensions by means of a very simple handling operation.

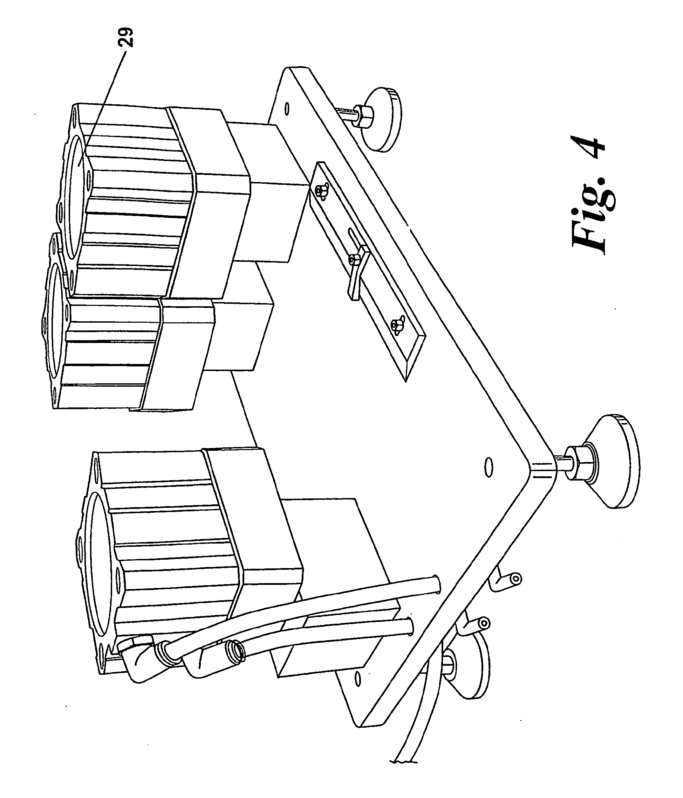

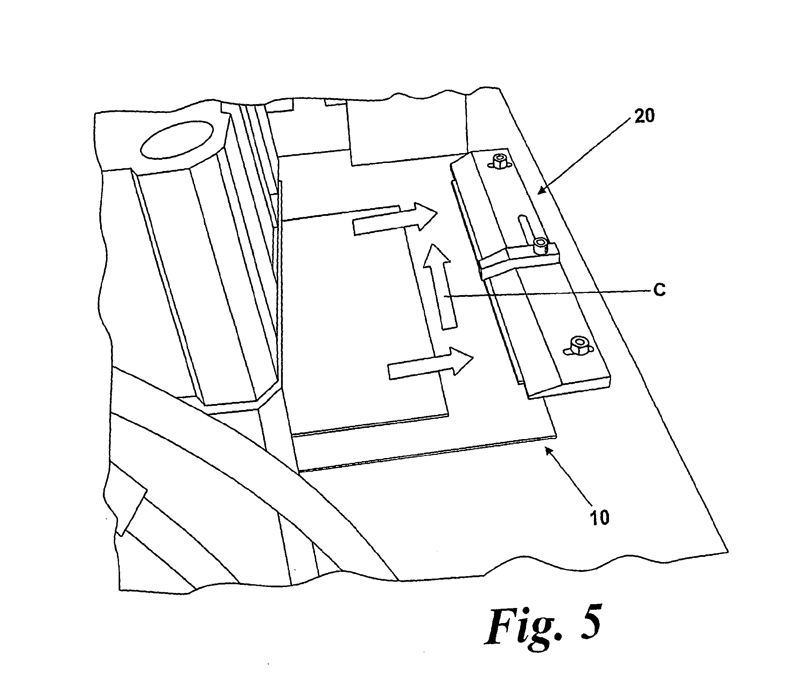

Turning now to Figures 4 and 5, it can be seen that, with this arrangement, the portion 28 of the plate 10 can be inserted into the slot of punch head 29 in a precisely defined position. Accordingly, the punched holes 13 (see Figure 1) will have precisely the intended special relationship with the image 11.

A longitudinal movement arrow C in Figure 5 is the reverse of arrow B shown in Figure 3 because the projection 24 is the other way around.

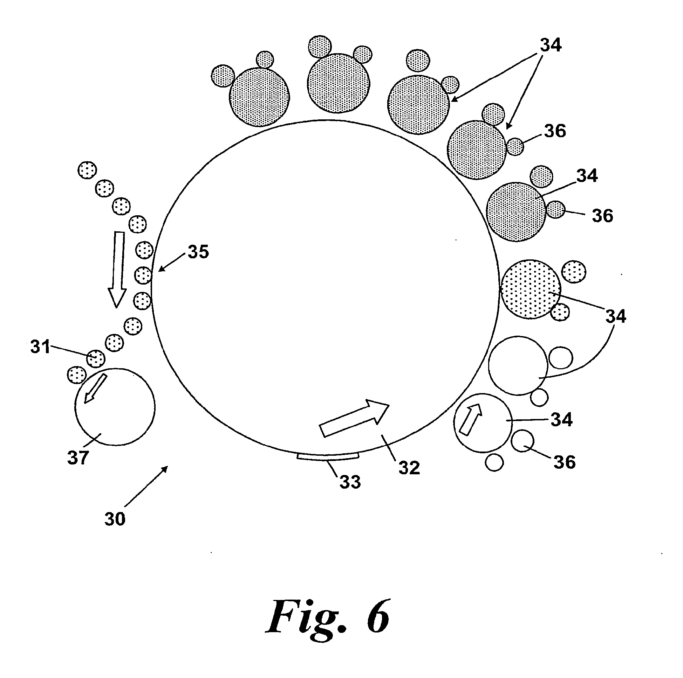

Figure 6 schematically illustrates a can decorator generally indicated at 30. It comprises a mandrel (not shown) for passing cans 31 along a path adjacent to a blanket cylinder 32 that carries discrete printing blankets, one of which is indicated at 33. These successively engage print rollers 34 as the cylinder 32 rotates to pick up the individual colour images from the respective rollers. Each blanket then prints its combined image on a can 31 at location 35. Ink rollers 36 apply to respective ink colour to the plate or plates 10 on their respective roller 34. The decorative cans 31 are varnished at 37.

It will be understood that for the combined image on the blanket 33, the location of the plates 10 on their respective rollers 34 needs to be extremely accurate. This accuracy is achieved by the plates of the invention

## Claims

1. A method of providing registration holes (13) in a printing plate (10) having a defined working area in the form of an image (11) in one portion of a surface of the plate **characterised in that** the method includes forming a raised portion (12) on the part of the surface of the plate not contained within the working area for providing a datum in a first direction (16) and an opening (14) in the raised portion (12), one wall (15) of the opening providing a datum in a direction orthogonal to the first.

2. A method as claimed in Claim 1 wherein the raised portion (12) is laser engraved directly from a digital image file.

3. A method as claimed in Claim 3 wherein the image (11) is laser engraved from a digital image file.

4. A method as claimed in any one of claim 1 to 3 further including providing a punch assembly including a bed (19) for receiving the plate, a punch extending along a dimension of the bed and a guide (20) extending at angle to the punch whereby the guide has a portion (22) overhanging the bed (19) to define a recess (23) for receiving an edge of a plate and to define a datum edge (26) against which the raised portion (12) can engage and having a formation for defining a further datum (27) orthogonal to the datum edge (26) and presenting the printing plate (10) to the punch assembly such that its raised portion datums engage respective datums (26, 27) on the guide and punching registration holes (13) when the printing plate is so located.

5. A printing plate (10) having a surface with a working area (11) in the form of an image (11) and a non-working area, **characterised in that** the non-working area (11) of the surface has a raised portion (12) for providing a datum (16) in a first direction and an opening (14) in the portion, one wall (15) of the opening providing a datum in a direction orthogonal to the first.

6. A plate as claimed in Claim 5 wherein the opening (14) is generally central in the raised portion.

7. A plate as claimed in Claim 5 or Claim 6 wherein the plate (10) is generally rectangular and the raised portion (12) extends parallel to an edge thereof.

8. A plate as claimed in any one of the preceding claims wherein the working area is rectangular and the raised portion (12) extends generally parallel to an edge thereof.

9. A plate as claimed in any one of the preceding claims wherein the surface includes an area for receiving punched location holes (13), said punch hole area being spaced from the working area (11) and the raised portion (12).

10. A plate as claimed in any one of claims 4 to 8, wherein the image (11) and/or the raised portion (12) are formed by laser engraving from a digital file direct.

## Patentansprüche

1. Verfahren zur Schaffung von Justierlöchern (13) in einer Druckplatte (10), die einen bestimmten Arbeitsbereich in Form eines Bildes (11) in einem Teil einer Oberfläche der Platte aufweist, **dadurch gekennzeichnet, daß** zu dem Verfahren gehören die Bildung eines erhabenen Teils (12) auf dem Teil der Oberfläche der Platte, der nicht in dem Arbeitsbereich enthalten ist, um einen Ausgangspunkt in einer ersten Richtung (16) und eine Öffnung (14) in dem erhabenen Teil (12) zu bilden, wobei eine Wand (15) der Öffnung einen Ausgangspunkt in einer Richtung senkrecht zu der ersten bildet.

2. Verfahren nach Anspruch 1, **dadurch gekennzeichnet, daß** der erhabene Teil (12) direkt von einer digitalen Bilddatei lasergraviert ist.

3. Verfahren nach Anspruch 1, **dadurch gekennzeichnet, daß** das Bild (11) von einer digitalen Bilddatei lasergraviert ist.

4. Verfahren nach einem der Ansprüche 1 bis 3, ferner **gekennzeichnet** eine Gesenk-Anordnung mit einem Bett (19) zur Aufnahme der Platte, einem Dorn, der sich längs einer Abmessung des Bettes erstreckt und einer Führung (20), die sich unter einem Winkel zu dem Dorn erstreckt, wobei die Führung einen Teil (22) aufweist, der über dem Bett (19) hängt, um eine Vertiefung (23) zur Aufnahme eines Randes einer Platte zu begrenzen sowie einen Ausgangspunktrand (26) zu definieren, den der erhabene Teil (12) berühren kann und der eine Ausbildung zur Festlegung eines weiteren Ausgangspunktes (27) aufweist, welcher rechtwinklig zu dem Ausgangspunktrand (26) angeordnet ist und um die Druckplatte (10) der Gesenk-Anordnung so zu präsentieren, daß die Ausgangspunkte ihres erhabenen Teils mit den entsprechenden Ausgangspunkten (26, 27) auf der Führung und den Durchstoß-Justierlöchern (13) in Eingriff treten, sobald die Druckplatte entsprechend angeordnet ist.

5. Druckplatte (10) mit einer Oberfläche, die einen Arbeitsbereich (11) in der Form eines Bildes (11) und einen Nichtarbeitsbereich aufweist, **dadurch gekennzeichnet, daß** der Nichtarbeitsbereich (11) der Oberfläche einen erhabenen Teil (12) aufweist, der einen Ausgangspunkt (16) in einer ersten Richtung und eine Öffnung (14) in dem Teil bildet, wobei eine Wand (15) der Öffnung einen Ausgangspunkt in einer Richtung schafft, die rechtwinklig zu der ersten verläuft.

6. Platte nach Anspruch 5, **dadurch gekennzeichnet, daß** die Öffnung (14) im allgemeinen mittig in dem erhabenen Teil liegt.

7. Platte nach Anspruch 5 oder Anspruch 6, **dadurch gekennzeichnet, daß** die Platte (10) im allgemeinen rechtwinklig ist und der erhabene Teil (12) sich parallel zu einem Rand von ihr erstreckt.

8. Platte nach einem der vorhergehenden Ansprüche, **dadurch gekennzeichnet, daß** der Arbeitsbereich rechteckig ist und der erhabene Teil (12) sich im allgemeinen parallel zu einem Rand des erhabenen Teils erstreckt.

9. Platte nach einem der vorhergehenden Ansprüche, **dadurch gekennzeichnet, daß** die Oberfläche einen Bereich zur Aufnahme von gestanzten Justierlöchern (13) aufweist, und daß der Stanzlochbereich von dem Arbeitsbereich (11) und dem erhabenen Teil (12) mit Abstand getrennt ist.

10. Platte nach einem der Ansprüche 4 bis 8, **dadurch gekennzeichnet, daß** das Bild (11) und / oder der erhabene Bereich (12) durch Lasergravierung direkt von einer digitalen Bilddatei hergestellt sind.

## Revendications

1. Procédé de création de trous de repérage (13) dans une plaque d'impression (10) ayant une zone de travail définie se présentant sous la forme d'une image (11) dans une partie d'une surface de la plaque, **caractérisé par le fait que** le procédé comprend la formation d'une partie surélevée (12) sur la partie de la surface de la plaque qui n'est pas contenue à l'intérieur de la zone de travail pour créer un repère dans une première direction (16) et une ouverture (14) dans la partie surélevée (12), une paroi (15) de l'ouverture fournissant un repère dans une direction orthogonale à la première direction.

2. Procédé selon la revendication 1, dans lequel la partie surélevée (12) est gravée au laser directement à partir d'un fichier image numérique.

3. Procédé selon la revendication 3, dans lequel l'image (11) est gravée au laser à partir d'un fichier image numérique.

4. Procédé selon l'une quelconque des revendications 1 à 3, comprenant en outre la disposition d'un ensemble poinçon comprenant un lit (19) destiné à recevoir la plaque, un poinçon s'étendant le long d'une dimension du lit et un guide (20) s'étendant selon un angle par rapport au poinçon, ce par quoi le guide a une partie (22) surplombant le lit (19) pour définir une cavité (23) destinée à recevoir un bord d'une plaque et pour définir un bord de repère (26) contre lequel la partie surélevée (12) peut s'engager et ayant une formation destinée à définir un autre repère (27) orthogonal au bord de repère (26) et à présenter la plaque d'impression (10) à l'ensemble poinçon de telle sorte que ses repères de partie surélevée engagent les repères respectifs (26, 27) sur le guide et les trous de repérage de poinçonnage (13) lorsque la plaque d'impression est ainsi positionnée.

5. Plaque d'impression (10) ayant une surface avec une zone de travail (11) se présentant sous la forme d'une image (11) et une zone de non travail, **caractérisée par le fait que** la zone de non travail (11) de la surface a une partie surélevée (12) destinée à créer un repère (16) dans une première direction et une ouverture (14) dans la partie, une paroi (15) de l'ouverture fournissant un repère dans une direction orthogonale à la première direction.

6. Plaque selon la revendication 5, dans laquelle l'ouverture (14) est globalement centrale dans la partie surélevée.

7. Plaque selon l'une des revendications 5 ou 6, dans laquelle la plaque (10) est globalement rectangulaire et la partie surélevée (12) s'étend parallèlement à un bord de celle-ci.

8. Plaque selon l'une quelconque des revendications précédentes, dans laquelle la zone de travail est rectangulaire et la partie surélevée (12) s'étend globalement parallèlement à un bord de celle-ci.

9. Plaque selon l'une quelconque des revendications précédentes, dans laquelle la surface comprend une zone destinée à recevoir des trous de positionnement poinçonnés (13), ladite zone à trous de poinçonnés étant espacée de la zone de travail (11) et de la partie surélevée (12).

10. Plaque selon l'une quelconque des revendications 4 à 8, dans laquelle l'image (11) et/ou la partie surélevée (12) sont formées par gravure au laser directement à partir d'un fichier numérique.
